# FASCICULE DE BREVET EUROPEEN

(11) **EP 3 273 258 B1**
(45) Date de publication et mention de la délivrance du brevet: **03.11.2021**
(21) Numéro de dépôt: 17174469.1
(22) Date de dépôt: 06.06.2017
(51) Int. Cl.: G01R 31/00, H02H 7/20, H02J 9/06, H02J 3/08, H02J 3/06, H02J 13/00, H02J 3/40

(54) **PROCÉDÉ DE COMMANDE D'UNE INSTALLATION ÉLECTRIQUE DEPUIS UN LIEU DISTANT**
VERFAHREN ZUR STEUERUNG EINER ELEKTRISCHEN ANLAGE VON EINEM ENTFERNTEN ORT AUS
METHOD FOR CONTROLLING AN ELECTRICAL INSTALLATION FROM A REMOTE LOCATION

(30) Priorité: 07.07.2016 FR 1656514
(43) Date de publication de la demande: 24.01.2018
(73) Titulaire: Schneider Electric Industries SAS, 92500 Rueil-Malmaison (FR)
(72) Inventeur: Message Thebaudeau, Laetitia, 38460 DIZIMIEU (FR)
(74) Mandataire: Mouney, Jérôme

(56) Documents cités:
- EP-A1- 2 390 981
- CA-A1- 2 815 813
- CN-B- 104 701 973
- DE-B3-102015 102 468
- FR-A1- 2 685 830
- FR-A1- 2 987 690
- Anonymous: "Transfer switch - Wikipedia, the free encyclopedia", , 2 July 2016 (2016-07-02), XP055664007, Retrieved from the Internet: URL:https://web.archive.org/web/2016070210 4543/https://en.wikipedia.org/wiki/Transfe r_switch [retrieved on 2020-01-31]

## Description

### Domaine technique de l'invention

La présente invention se rapporte à un procédé de commande d'une installation électrique depuis un lieu distant tel qu'un centre de téléconduite ou de contrôle-commande qui est éloigné de l'installation électrique. L'invention concerne plus particulièrement la commande de basculement du raccordement d'une sous-station entre un réseau électrique principal de moyenne ou haute tension, c'est-à-dire supérieur à 1000V, et une source auxiliaire d'alimentation de secours (back-up), notamment dans le but d'effectuer une opération de maintenance préventive.

### Etat de la technique

De manière connue, lorsqu'une sous-station a la possibilité de se raccorder à une source d'alimentation auxiliaire de secours en cas de perte du réseau d'alimentation électrique principal, il est souhaitable de vérifier périodiquement le bon démarrage et le bon couplage de cette source d'alimentation auxiliaire, de façon à s'assurer qu'en cas de besoin (défaillance du réseau principal par exemple), le basculement du réseau principal vers la source auxiliaire sera effectivement opérationnel. En fonction des besoins de l'installation, la source auxiliaire peut comporter un ou plusieurs générateurs auxiliaires d'alimentation, tels que groupe électrogène ou genset.

Cette vérification périodique, qui peut être par exemple mensuelle, entraîne généralement une opération de maintenance sur le site de la sous-station avec le déplacement d'opérateurs sur ce site, et nécessite également l'interruption de l'alimentation du réseau principal. Ceci implique donc une logistique particulière et présente les inconvénients de devoir envoyer les équipes sur place et de devoir momentanément couper les charges électriques alimentées par la sous-station.

De manière générale, l'opération de maintenance périodique est faite par les opérateurs en coupant d'abord le réseau principal, puis en effectuant un délestage de charges si besoin est (en fonction de la puissance du générateur auxiliaire), en couplant les charges non-délestées au générateur auxiliaire, en démarrant ce dernier pour vérifier le bon fonctionnement. Inversement, il faut ensuite découpler les charges du générateur, interrompre le délestage, et rebasculer les charges sur le réseau principal. Il y a donc deux interruptions successives d'alimentation des charges dans cette procédure périodique.

Les documents suivants représentent différents antécédents pertinents pour la présente invention:

FR 2685830 A1 décrit une installation dans laquelle, en fonctionnement normal, deux charges sont alimentées par respectivement deux alimentations sans coupure distinctes. De cette façon, il est possible de basculer temporairement une première charge sur la seconde alimentation sans coupure, afin de pouvoir intervenir et/ou remplacer la première alimentation sans coupure de façon sûre.

EP 2390981 A1 concerne un dispositif de mise en sécurité d'une installation de génération d'énergie électrique destiné à être connecté un module de génération d'énergie électrique via au moins deux première bornes de connexion et destiné à être connecté à un réseau de distribution électrique via au moins deux secondes bornes de connexion. Le dispositif de mise en sécurité comportant des moyens de déconnexion électrique du module de génération d'énergie électrique et du réseau de distribution électrique.

FR 2 985 690 décrit un procédé pour maintenir une installation électrique et redémarrer une partie de l'installation après détection de perturbations ou de dysfonctionnements.

DE102015102468 décrit un système d'alimentation dans lequel, en cas de défaillance du système, les moyens de commutation sont désactivés et l'ensemble des consommateurs est séparé du réseau d'alimentation d'énergie et le dispositif de commutation est actionné par le circuit de commande, qui établit une connexion locale avec un système d'alimentation local. Une synchronisation du réseau isolé qui fournit le dispositif d'alimentation local au réseau d'alimentation est réalisée en premier.

CA 2815813 A1 décrit un procédé pour tester automatiquement un système d'alimentation électrique de secours qui fournit une alimentation de remplacement à un système électrique en cas de panne de courant, le procédé comprenant une étape de commutation de transfert automatique pour faire passer l'état d'un état normal à un état de test afin de lancer un test du système d'alimentation électrique de secours en déconnectant temporairement le système électrique de la source d'alimentation principale.

Les documents "Transfer switch - Wikipedia, the free encyclopedia"(référence Espacenet XP55664007) et CN104701973 A révèlent comment un transfert automatique peut être mis en oeuvre comme un transfert à transition fermée (CTTS), impliquant des étapes de vérification et de synchronisation pour assurer une transition en douceur.

### Exposé de l'invention

Le but de l'invention est donc d'éviter les inconvénients précités, à savoir éviter les interruptions d'alimentation des charges non délestées et la mobilisation d'opérateurs sur site, lors de ces opérations de maintenance périodique.

Pour cela, l'invention décrit un procédé de commande d'une installation électrique selon la revendication 1. Les revendications dépendantes définissent d'autres incarnations avantageuses.

### Brève description des figures

D'autres caractéristiques et avantages vont apparaître dans la description détaillée qui suit, faite en regard des dessins annexés dans lesquels :
- la figure 1 représente un schéma simplifié d'une installation de distribution électrique avec un réseau de couplage pouvant être alimenté à partir d'une source principale et d'une source auxiliaire,
- la figure 2 montre une variante de la figure 1 comportant un interrupteur de couplage et plusieurs générateurs auxiliaires,
- la figure 3 est un organigramme simplifié du procédé de commande selon l'invention.

### Description détaillée d'au moins un mode de réalisation

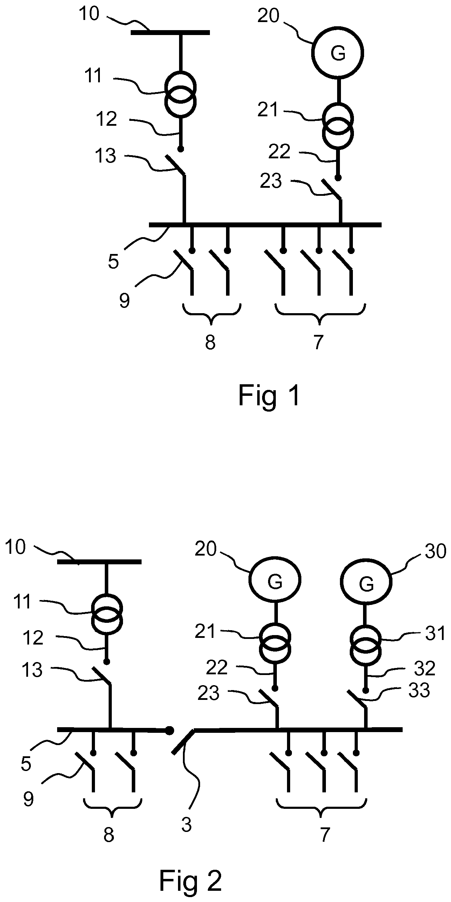

En référence à la figure 1, une installation de distribution électrique comporte un réseau électrique de couplage 5 qui peut être alimenté par deux sources de courant distinctes : une source d'alimentation dite principale qui est un réseau électrique de distribution 10 tel que le réseau de distribution public, et une source d'alimentation dite auxiliaire qui comprend un générateur auxiliaire 20 tel qu'un groupe électrogène, ou genset, ou générateur de secours (backup).

Le réseau électrique de couplage 5 est raccordé à la source principale 10 au travers d'une ligne de distribution principale 12 qui comporte de façon classique différents appareils, par exemple un transformateur 11 et au moins un interrupteur principal 13. De même, le réseau de couplage 5 est raccordé à la source auxiliaire au travers d'une ligne de distribution auxiliaire 22 qui comporte de façon classique différents appareils, par exemple un transformateur 21 et au moins un interrupteur auxiliaire 23. D'autres appareils de commutation peuvent évidemment exister, notamment entre le réseau de distribution 10 et le transformateur 11, mais ne sont pas représentés en figure 1 par souci de simplification. Dans le présent document, le terme "interrupteur" regroupe tout appareil de type interrupteur, sectionneur, disjoncteur, disjoncteur-sectionneur ou interrupteur-sectionneur.

Le réseau de couplage 5 permet d'alimenter électriquement différentes charges 7, 8. Optionnellement, les charges 7, 8 peuvent se répartir en plusieurs catégories à savoir des charges dites prioritaires 7, que l'on souhaite pouvoir alimenter prioritairement en permanence, et des charges dites non-prioritaires 8, qu'il est possible de délester en fonction de la puissance électrique disponible sur le réseau de couplage 5. Dans l'exemple de la figure 1, toutes les charges 7, 8 sont individuellement raccordées au réseau de couplage 5 par l'intermédiaire d'un interrupteur de branchement 9.

La source d'alimentation auxiliaire peut indifféremment comprendre un ou plusieurs générateurs auxiliaires raccordés en parallèle sur le réseau de couplage 5. Ainsi, dans l'exemple de la figure 2, la source d'alimentation auxiliaire comprend deux générateurs auxiliaires 20, respectivement 30, qui sont raccordés en parallèle sur le réseau de couplage 5 via une ligne de distribution auxiliaire 22, respectivement 32, un transformateur 21, respectivement 31 et un interrupteur auxiliaire 23, respectivement 33. Cette configuration avec plusieurs générateurs auxiliaires 20, 30 permet évidemment de disposer d'une puissance disponible supérieure pour alimenter les charges 7, 8 en cas de défaillance de la source principale 10.

En mode de fonctionnement normal, le réseau de couplage 5 est alimenté par la source principale 10, laquelle est généralement suffisamment puissante pour alimenter l'ensemble des charges 7, 8 raccordées au réseau de couplage 5. La source auxiliaire est donc déconnectée car elle est d'ordinaire utilisée comme source d'alimentation de secours en cas de défaillance de la source principale 10. En mode de fonctionnement normal, l'interrupteur principal 13 est donc en position fermée (ou passant) et le ou les interrupteurs auxiliaires 23, 33 sont en position ouverte (ou bloquant). Dans la variante représentée en figure 2 (voir plus loin) lorsqu'il existe un interrupteur de couplage 3, celui-ci est également en position fermée (ou passant), en mode de fonctionnement normal.

Eventuellement, la source auxiliaire pourrait cependant être aussi utilisée temporairement comme complément en cas de puissance disponible insuffisante de la source principale 10, par exemple pour éviter un black-out du réseau principal lors d'une surcharge ponctuelle ou d'une congestion située en amont.

Pour s'assurer que la source auxiliaire est bien disponible à tout moment, c'est-à-dire pour s'assurer qu'en cas de défaillance de la source principale 10, l'installation sera bien capable de basculer sur la source auxiliaire pour alimenter tout ou partie des charges 7, 8, il convient de faire régulièrement une vérification des procédures de démarrage et de couplage du ou des générateurs auxiliaires 20, 30.

L'installation de distribution électrique est pilotée depuis un poste de contrôle situé à distance (non représenté sur les figures), tel que par exemple un poste de supervision SCADA situé dans un centre de téléconduite. Ce poste de contrôle distant communique avec les différents appareils de l'installation électrique par un réseau de communication filaire et/ou wireless et est donc notamment capable d'envoyer à distance des ordres de fermeture et d'ouverture aux différents interrupteurs de l'installation. De même, le poste de contrôle distant communique avec différents appareils de mesure ou relais de détection de l'installation pour recevoir toutes les mesures ou tous les états utiles, notamment des mesures de tension, courant, fréquence des différentes lignes et réseaux électriques.

Le procédé de commande selon l'invention a donc pour but de faire une opération de maintenance préventive périodique, par exemple mensuelle, en vérifiant la disponibilité et le bon fonctionnement de la source auxiliaire, sans perturber l'alimentation des charges, en particulier des charges prioritaires 7, et sans nécessiter d'intervention locale des opérateurs. L'opération de maintenance est avantageusement réalisée à partir du poste de contrôle distant qui communique avec les automatismes locaux de commande gérant l'installation électrique.

On suppose qu'au départ du procédé de commande, l'installation électrique est en fonctionnement normal, c'est-à-dire que le réseau de couplage 5 est uniquement raccordé à la source principale 10, et que la source auxiliaire comporte un seul générateur auxiliaire 20. Lorsqu'une opération de maintenance est décidée, il faut d'abord démarrer le générateur auxiliaire 20, si cela n'a pas été déjà le cas par ailleurs. Ce démarrage peut être effectué par un ordre de démarrage du générateur auxiliaire 20 envoyé à partir du poste de contrôle distant.

Une fois que le générateur auxiliaire 20 est démarré, le procédé de commande prévoit une première étape de synchronisation du générateur auxiliaire 20 avec la source principale 10. Cette première étape de synchronisation est nécessaire avant de pouvoir basculer l'alimentation du réseau de couplage 5 de la source principale vers la source auxiliaire. En effet, comme un but de l'invention est de ne pas interrompre l'alimentation des charges prioritaires pendant l'opération de maintenance, ceci signifie que, pendant au moins une courte durée, le réseau de couplage 5 sera raccordé à la fois à la source principale et à la source auxiliaire, c'est-à-dire que l'interrupteur principal 13 et l'interrupteur auxiliaire 23 seront simultanément en position fermée pendant quelques centaines de millisecondes, voire quelques secondes.

Cette première étape de synchronisation comporte donc une phase de mesure de grandeurs électriques relatives à la source principale et à la source auxiliaire et une phase de vérification, depuis le poste de contrôle distant, que les grandeurs électriques mesurées du côté de la source principale sont compatibles avec les grandeurs électriques mesurées du côté de la source auxiliaire, afin de pouvoir autoriser la fermeture de l'interrupteur auxiliaire 23 et donc d'avoir la source principale et la source auxiliaire raccordées en même temps au réseau de couplage 5.

Si cette vérification n'est pas faite, une perturbation de l'installation pourra apparaitre et les équipements de l'installation électrique (dont le générateur auxiliaire mais aussi les charges) risquent d'être endommagés. Pour considérer que les grandeurs électriques mesurées sont compatibles, cela signifie qu'il faut vérifier que les tensions côté source principale et côté source auxiliaire ont la même amplitude, la même fréquence, la même phase angulaire, la même forme d'onde, et, dans le cas de systèmes multiphases, la même séquence de rotation des phases.

Les deux dernières conditions (à savoir "forme d'onde" et "séquence des phases") sont des éléments fixés par la construction du générateur auxiliaire et ses connexions à l'installation électrique. On peut donc considérer que ces conditions ont été vérifiées lors de la mise en service de l'installation et n'ont pas besoin d'être re-contrôlées systématiquement. Par contre, les trois premières conditions (à savoir "amplitude", "fréquence", "phase angulaire") doivent quant à elles être systématiquement vérifiées à chaque fois que la source principale et la source auxiliaire vont être connectées en parallèle.

En effet, si les amplitudes des tensions de la source principale et de la source auxiliaire ne sont pas suffisamment proches, alors un flux soudain de puissance réactive de plusieurs méga voltampères réactifs (MVAr) peut apparaître à la fermeture de l'interrupteur auxiliaire. Les tolérances sur ces écarts d'amplitude sont à la fois fonction des paramètres du générateur et de ceux du réseau. On considère généralement qu'un écart maximal de +/- 5% est admissible pour que les amplitudes des tensions soient compatibles. Ce contrôle d'écart entre les amplitudes se fait sur les valeurs de tension soit maximales, soit efficaces.

Si les fréquences côté source principale et côté source auxiliaire ne coïncident pas avant la fermeture de l'interrupteur auxiliaire, alors un flux soudain de puissance active de plusieurs mégawatts (MW) peut apparaître, pour essayer d'établir une fréquence commune des deux côtés. Comme précédemment, la différence acceptable est spécifique et dépend à la fois des paramètres du générateur auxiliaire et de ceux du réseau principal. On considère cependant de manière générale qu'il faut au moins rendre l'écart entre les fréquences inférieur à 1Hz, voire à 100mHz, pour que les fréquences soient compatibles.

Si la différence de phase angulaire entre le côté source principale et le côté source auxiliaire n'est pas minimisée, alors une augmentation importante du flux de puissance active de plusieurs mégawatts (MW) peut apparaître à la fermeture de l'interrupteur auxiliaire. Cette troisième condition est presque la plus importante. Typiquement, il faut au moins rendre la différence de phase angulaire la plus proche possible de 0°. On considère généralement qu'un écart maximal de +/- 10° est admissible pour que la différence de phase angulaire soit compatible.

Dans le cas où les grandeurs électriques mesurées de la source principale et du générateur auxiliaire ne remplissent pas une des conditions ci-dessus pour être compatibles, l'étape de synchronisation comprend alors une phase de correction des grandeurs électriques relatives au générateur auxiliaire 20. Cette phase de correction est mise en oeuvre à partir du poste de contrôle distant. Elle consiste par exemple à ajuster progressivement, c'est-à-dire par paliers successifs pour éviter des variations brusques, des paramètres tels que la vitesse du moteur et la tension du générateur auxiliaire, via un régulateur de vitesse et un régulateur de tension du générateur auxiliaire. Ainsi, on fait varier les grandeurs telles que l'amplitude, la fréquence et/ou la phase angulaire de la tension auxiliaire de façon à ce que les écarts entre ces valeurs et les valeurs correspondantes de la tension principale soient compatibles avec une mise en parallèle des sources principale et auxiliaire.

Le poste de contrôle distant reçoit donc les mesures effectuées localement durant la phase de mesure et comporte des moyens logiciels de calcul et d'analyse permettant de vérifier si les mesures sont compatibles, c'est-à-dire si la mise en parallèle des deux sources est autorisée, et éventuellement d'agir sur le générateur auxiliaire 20 pour faire les corrections nécessaires.

Lorsque les conditions sont remplies, le procédé de commande prévoit alors une étape d'envoi d'un ordre de fermeture de l'interrupteur auxiliaire 23 par le poste de contrôle distant, puis une étape d'envoi d'un ordre d'ouverture de l'interrupteur principal 13 par le poste de contrôle distant, de façon à basculer le réseau de couplage 5 sur la source auxiliaire 20.

Dans le cas où la source auxiliaire comporte plusieurs générateurs auxiliaires 20, respectivement 30 comme indiqué en figure 2, il convient alors de réaliser les différentes phases de l'étape de synchronisation décrite ci-dessus pour chaque générateur auxiliaire 20, respectivement 30, avant de pouvoir fermer l'interrupteur auxiliaire correspondant 23, respectivement 33.

Une fois le réseau de couplage 5 alimenté uniquement par la source auxiliaire, le poste distant effectue une étape de contrôle permettant de vérifier que les charges 7, 8 non délestées sont correctement alimentées par la source auxiliaire, notamment à partir de mesures effectuées sur le réseau de couplage 5. Bien que non détaillée dans le présent document, cette étape correspond à la vérification des conditions basiques connues d'une répartition des flux (power load flow), à savoir tension et fréquence du système présentant des valeurs situées dans la bande admissible autour de leur valeur nominale respective, et équilibre des puissances (active et réactive) produites et consommées.

Optionnellement, le procédé prévoit que si l'installation électrique comporte des charges prioritaires 7 et que l'on ne souhaite pas les arrêter pour faire une vérification périodique de disponibilité de la source auxiliaire, le procédé de commande comprend une étape de détermination d'une puissance consommée P_{LP} par l'ensemble des charges prioritaires 7 et une étape de décision, par le poste de conduite distant, qui autorise la mise en œuvre du basculement de la source principale vers la source auxiliaire seulement si cette puissance consommée P_{LP} par les charges prioritaires 7 est inférieure à la puissance maximale P_{AUX} qui peut être fournie par le (ou les) générateur(s) auxiliaire(s) 20, 30 de la source auxiliaire.

De plus, si l'installation électrique comporte des charges non prioritaires 8 que l'on accepte d'interrompre pour faire une vérification périodique de disponibilité de la source auxiliaire, le procédé de commande comprend une étape supplémentaire avant d'ouvrir l'interrupteur principal 13. Cette étape supplémentaire est une étape de détermination des puissances consommées P_{LNP} par les différentes charges non prioritaires 8 et une étape de coupure sélective qui permet de délester une ou plusieurs charges non prioritaires 8 de façon à ce que la somme des puissances consommées P_{LP} par les charges prioritaires 7 et des puissances consommées P_{LNP} par les charges non prioritaires 8 non délestées soit inférieure à la puissance maximale P_{AUX} qui peut être fournie par la source auxiliaire.

Cette étape de coupure sélective est effectuée par le poste de contrôle distant qui est donc capable de commander individuellement les interrupteurs de branchement 9 des charges non prioritaires 8 qui devront être éventuellement délestées.

Une fois que l'étape de contrôle a permis de vérifier que les charges 7, 8 non délestées sont correctement alimentées par la source auxiliaire pendant une durée prédéterminée, par exemple de l'ordre d'une dizaine de secondes, cela signifie que la vérification du bon fonctionnement de la source auxiliaire a été réalisée et on peut donc revenir au mode de fonctionnement normal.

Pour cela, il va falloir de nouveau coupler en parallèle la source principale et la source auxiliaire de façon à éviter une rupture d'alimentation des charges. C'est pourquoi, le procédé de commande comporte une deuxième étape de synchronisation de la source auxiliaire avec la source principale comprenant une phase de mesure de grandeurs électriques relatives à la source principale et au générateur auxiliaire et une phase de vérification, depuis le poste de contrôle distant, que les grandeurs électriques mesurées de la source principale et du générateur auxiliaire sont compatibles. Le déroulement de cette deuxième étape de synchronisation est similaire au fonctionnement de la première étape de synchronisation décrit précédemment.

Une variante est représentée en figure 2, dans laquelle le réseau de couplage 5 comporte un interrupteur de couplage 3 (appelé aussi bus-tie) qui sépare le réseau de couplage 5 en deux parties. Une première partie comporte la source principale 10 et les charges non-prioritaires 8 et une seconde partie comporte le ou les générateurs auxiliaires 20, 30 et les charges prioritaires 7. L'existence de cet interrupteur de couplage 3 est complètement indépendante du fait d'avoir un ou plusieurs générateurs auxiliaires. Ainsi, d'autres configurations que la figure 2 sont envisageables, par exemple un interrupteur de couplage 3 et un seul générateur auxiliaire 20, ou pas d'interrupteur de couplage 3 et plusieurs générateurs auxiliaires 20, 30.

Dans cette variante, le procédé de commande comprend une étape de détermination d'une puissance consommée par les charges prioritaires et par les charges non-prioritaires, et une étape d'ouverture de l'interrupteur de couplage depuis le poste de contrôle distant pour déconnecter les charges non-prioritaires, dans le cas où la somme des puissances consommées par les charges prioritaires et par les charges non-prioritaires est supérieure à la puissance disponible fournie par la source auxiliaire.

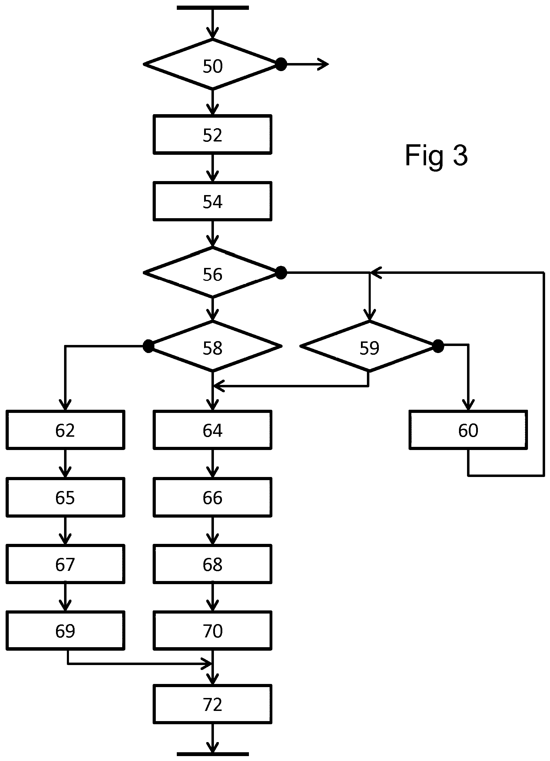

La figure 3 donne une vue d'un organigramme simplifié correspondant à un mode de réalisation du procédé de commande selon l'invention. Cet organigramme est simplifié car il ne comporte pas certaines étapes évidentes pour l'homme du métier, telles que le démarrage ou l'arrêt du ou des générateurs auxiliaires de la source auxiliaire (groupe électrogène), les détails de calcul de la puissance maximale pouvant être délivrée par la source auxiliaire, la mesure de la puissance consommée à l'instant du test par les charges prioritaires et/ou les charges non prioritaires. Il en est de même pour tous les éventuels échanges de notification d'événements ou d'états vers le centre de supervision SCADA.

Dans cet organigramme, le premier bloc 50 est un premier test qui est effectué dans l'hypothèse où l'on ne veut pas poursuivre l'opération de maintenance périodique si cela doit entraîner une coupure de certaines charges prioritaires. Le bloc 50 représente donc l'étape de détermination de la puissance consommée P_{LP} par les charges prioritaires et l'étape de décision autorisant la mise en œuvre du procédé de commande seulement si la puissance consommée P_{LP} par les charges prioritaires est inférieure à la puissance disponible P_{AUX} fournie par la source auxiliaire. Si le test est positif (P_{LP} < P_{AUX}), l'organigramme passe au bloc 52, sinon le procédé de commande se termine car cela signifie que la source auxiliaire ne sera pas capable à cet instant donné d'alimenter toutes les charges prioritaires. Dans ce cas le test de maintenance périodique pourra être reporté à un autre moment plus opportun.

Le bloc 52 représente la première étape de synchronisation de la source auxiliaire avec la source principale, incluant la phase de correction éventuelle si nécessaire. Une fois les sources synchronisées, le bloc suivant 54 correspond à la fermeture du ou des interrupteurs auxiliaires 20, 30 pour raccorder la source auxiliaire au réseau de couplage 5. Le bloc suivant 56 est un test pour déterminer si le réseau de couplage 5 comporte l'option d'un interrupteur de couplage 3 (bus-tie). Si l'installation électrique comporte un interrupteur de couplage 3, on passe au bloc 58, sinon on passe au bloc 59.

Les blocs 58 et 59 permettent de tester si la somme des puissances consommées par les charges prioritaires P_{LP} et par les charges non-prioritaires P_{LNP} non délestées est inférieure à la puissance disponible P_{AUX} fournie par la source auxiliaire.

Dans le cas du bloc 59 (sans interrupteur de couplage 3), si le test est négatif (c'est-à-dire P_{LP} + P_{LNP} > P_{AUX}), alors on passe au bloc 60 qui correspond à l'étape de coupure sélective permettant de déconnecter une ou plusieurs charges non prioritaires en ouvrant leur interrupteur de branchement 9. On se reboucle ainsi de façon itérative sur les blocs 59 et 60, tant que le test du bloc 59 n'est pas positif.

Dans le cas du bloc 58 (avec interrupteur de couplage 3), si le test est négatif (P_{LP} + P_{LNP} > P_{AUX}), alors on passe au bloc 62 dans lequel on ouvre l'interrupteur de couplage 3 de façon à pouvoir tester le fonctionnement de la source auxiliaire pour alimenter les charges prioritaires 7 uniquement. Ce cas ne permet pas de tester le bon fonctionnement de l'interrupteur principal 13 (ouverture et fermeture) mais permet néanmoins de tester le bon fonctionnement de l'interrupteur de couplage 3. L'organigramme passe ensuite au bloc 65 qui permet d'effectuer l'étape de contrôle pour vérifier que la ou les charges sont correctement alimentées par la source auxiliaire.

Une fois cette étape de contrôle 65 effectuée, l'opération de maintenance périodique peut se terminer et on passe donc au bloc 67 qui correspond à la deuxième étape de synchronisation de la source auxiliaire avec la source principale, incluant la phase de correction éventuelle si nécessaire.

Une fois la deuxième synchronisation effectuée dans le bloc 67, le bloc suivant 69 correspond à la refermeture de l'interrupteur de couplage 3 pour raccorder de nouveau la source principale au réseau de couplage 5. Durant ce bloc 69, on effectue également ensuite la fermeture des interrupteurs de branchement 9 des charges non-prioritaires éventuellement délestées. Le bloc suivant sera le bloc 72.

Par contre, si le test effectué dans les blocs 58 et 59 est positif (P_{LP} + P_{LNP} < P_{AUX}), l'organigramme passe alors au bloc 64 dans lequel on ouvre l'interrupteur principal 13. Le réseau de couplage 5 est alors alimenté uniquement par la source auxiliaire. L'organigramme passe ensuite au bloc 66 qui permet d'effectuer l'étape de contrôle pour vérifier que la ou les charges sont correctement alimentées par la source auxiliaire.

Une fois cette étape de contrôle 66 effectuée, l'opération de maintenance périodique peut se terminer et on passe donc au bloc 68 qui correspond à la deuxième étape de synchronisation de la source auxiliaire avec la source principale, incluant la phase de correction éventuelle si nécessaire.

Une fois la deuxième synchronisation effectuée dans le bloc 68, le bloc suivant 70 correspond à la fermeture de l'interrupteur principal 13 pour raccorder de nouveau la source principale au réseau de couplage 5. Durant ce bloc 70, on effectue également ensuite la fermeture des interrupteurs de branchement 9 des charges non-prioritaires éventuellement délestées.

Enfin, le dernier bloc 72 représente l'étape d'ouverture du ou des interrupteurs auxiliaires de façon à revenir au mode de fonctionnement normal de l'installation dans lequel l'ensemble des charges 7, 8 est alimenté par la source principale 10. Bien que non décrite dans cet organigramme, cette étape est suivie d'une étape d'arrêt du ou des générateur(s) auxiliaire(s). Enfin un rapport sur le déroulement du test de maintenance périodique est édité et notifié au centre de supervision.

## Revendications

1. Procédé de commande d'une installation électrique à partir d'un poste de contrôle distant, l'installation électrique comprenant un réseau électrique de couplage (5) alimentant plusieurs charges (7, 8) réparties entre des charges dites prioritaires (7) et des charges dites non-prioritaires (8), un interrupteur principal (13) pour connecter une source principale (10) d'alimentation au réseau de couplage (5) et un interrupteur auxiliaire (23) pour connecter une source auxiliaire (20) d'alimentation au réseau de couplage (5), le procédé de commande comportant :
- Une étape de détermination d'une puissance consommée par les charges prioritaires (7) et une étape de décision qui autorise la mise en oeuvre du procédé de commande seulement si la puissance consommée par les charges prioritaires (7) est inférieure à une puissance disponible fournie par la source auxiliaire (20),
- Une étape de synchronisation de la source auxiliaire (20) avec la source principale (10) comprenant une phase de mesure de grandeurs électriques relatives à la source principale et à la source auxiliaire et une phase de vérification, depuis le poste de contrôle distant, que les grandeurs électriques mesurées de la source principale et de la source auxiliaire sont compatibles, et si, durant la phase de vérification, les grandeurs électriques mesurées relatives à la source principale (10) et à la source auxiliaire (20) ne sont pas compatibles, l'étape de synchronisation comprend en outre une phase de correction, à partir du poste de contrôle distant, de paramètres relatifs à la source auxiliaire (20),
- Une étape d'envoi d'un ordre de fermeture de l'interrupteur auxiliaire (23) à partir du poste de contrôle distant,
- Une étape d'envoi d'un ordre d'ouverture de l'interrupteur principal (13) à partir du poste de contrôle distant,
- Une étape de contrôle, depuis le poste de contrôle distant, que la ou les charges (7, 8) sont alimentées par la source auxiliaire (20).

2. Procédé de commande selon la revendication 1, **caractérisé en ce que**, après l'étape de contrôle, le procédé comporte ensuite une deuxième étape de synchronisation de la source auxiliaire (20) avec la source principale (10) comprenant une phase de mesure de grandeurs électriques relatives à la source principale et à la source auxiliaire et une phase de vérification, depuis le poste de contrôle distant, que les grandeurs électriques mesurées de la source principale et de la source auxiliaire sont compatibles.

3. Procédé de commande selon la revendication 2, **caractérisé en ce que**, après la deuxième étape de synchronisation, le procédé comporte une étape d'envoi d'un ordre de fermeture de l'interrupteur principal (13) à partir du poste de contrôle distant puis une étape d'envoi d'un ordre d'ouverture de l'interrupteur auxiliaire (23) à partir du poste de contrôle distant.

4. Procédé de commande selon la revendication 1, dans lequel chaque charge est connectée au réseau électrique de couplage (5) par un interrupteur de branchement (9), **caractérisé en ce que** le procédé comprend une étape de détermination d'une puissance consommée par les charges prioritaires (7) et par les charges non-prioritaires (8), et une étape de coupure sélective qui permet d'ouvrir un ou plusieurs interrupteurs de branchement (9) depuis le poste de contrôle distant, de façon que la somme des puissances consommées par les charges prioritaires et par les charges non-prioritaires soit inférieure à la puissance disponible fournie par la source auxiliaire.

5. Procédé de commande selon la revendication 1, dans lequel le réseau électrique de couplage (5) comporte également un interrupteur de couplage (3) entre les charges prioritaires (7) et les charges non-prioritaires (8), **caractérisé en ce que** le procédé comprend une étape de détermination d'une puissance consommée par les charges prioritaires et par les charges non-prioritaires, et une étape d'ouverture de l'interrupteur de couplage depuis le poste de contrôle distant pour déconnecter les charges non-prioritaires, dans le cas où la somme des puissances consommées par les charges prioritaires et par les charges non-prioritaires est supérieure à la puissance disponible fournie par la source auxiliaire.

6. Procédé de commande selon la revendication 1, **caractérisé en ce qu'**il comporte une étape préalable d'envoi d'un ordre de démarrage du générateur auxiliaire à partir du poste de contrôle distant.

7. Procédé de commande selon la revendication 1, **caractérisé en ce que** la source auxiliaire comporte plusieurs générateurs auxiliaires (20, 30) raccordés chacun en parallèle au réseau de couplage (5) par un interrupteur auxiliaire (23, 33₎.

8. Procédé de commande selon la revendication 1, **caractérisé en ce que** les grandeurs électriques mesurées comprennent l'amplitude, la fréquence et la phase angulaire des tensions de la source principale et de la source auxiliaire.

## Patentansprüche

1. Verfahren zur Steuerung einer elektrischen Anlage von einer entfernten Steuerstation aus, wobei die elektrische Anlage Folgendes beinhaltet: ein elektrisches Koppelnetz (5), das mehrere Lasten (7, 8), die in prioritäre Lasten (7) und nicht prioritäre Lasten (8) unterteilt sind, mit Strom versorgt, einen Hauptschalter (13), um eine Hauptversorgungsquelle (10) mit dem Koppelnetz (5) zu verbinden, und einen Hilfsschalter (23), um eine Hilfsversorgungsquelle (20) mit dem Koppelnetz (5) zu verbinden, wobei das Steuerverfahren Folgendes umfasst:
- einen Schritt des Bestimmens einer durch die prioritären Lasten (7) verbrauchten Leistung und einen Schritt des Entscheidens, der die Umsetzung des Steuerverfahrens nur dann gestattet, wenn die durch die prioritären Lasten (7) verbrauchte Leistung kleiner als eine durch die Hilfsquelle (20) bereitgestellte verfügbare Leistung ist,
- einen Schritt des Synchronisierens der Hilfsquelle (20) mit der Hauptquelle (10), der eine Phase des Messens von elektrischen Größen in Bezug auf die Hauptquelle und in Bezug auf die Hilfsquelle und eine Phase des Überprüfens, von der entfernten Steuerstation aus, dass die gemessenen elektrischen Größen der Hauptquelle und der Hilfsquelle kompatibel sind, beinhaltet, und wobei, wenn während der Phase des Überprüfens die gemessenen elektrischen Größen in Bezug auf die Hauptquelle (10) und in Bezug auf die Hilfsquelle (20) nicht kompatibel sind, der Schritt des Synchronisierens ferner eine Phase des Korrigierens, von der entfernten Steuerstation aus, von Parametern in Bezug auf die Hilfsquelle (20) beinhaltet,
- einen Schritt des Sendens eines Befehls zum Schließen des Hilfsschalters (23) von der entfernten Steuerstation aus,
- einen Schritt des Sendens eines Befehls zum Öffnen des Hauptschalters (13) von der entfernten Steuerstation aus,
- einen Schritt des Kontrollierens, von der entfernten Steuerstation aus, dass die eine oder die mehreren Lasten (7, 8) durch die Hilfsquelle (20) mit Strom versorgt werden.

2. Steuerverfahren nach Anspruch 1, **dadurch gekennzeichnet, dass** das Verfahren nach dem Kontrollschritt anschließend einen zweiten Schritt des Synchronisierens der Hilfsquelle (20) mit der Hauptquelle (10) umfasst, der eine Phase des Messens von elektrischen Größen in Bezug auf die Hauptquelle und in Bezug auf die Hilfsquelle und eine Phase des Überprüfens, von der entfernten Steuerstation aus, dass die gemessenen elektrischen Größen der Hauptquelle und der Hilfsquelle kompatibel sind, beinhaltet.

3. Steuerverfahren nach Anspruch 2, **dadurch gekennzeichnet, dass** das Verfahren nach dem zweiten Schritt des Synchronisierens einen Schritt des Sendens eines Befehls zum Schließen des Hauptschalters (13) von der entfernten Steuerstation aus und in Folge einen Schritt des Sendens eines Befehls zum Öffnen des Hilfsschalters (23) von der entfernten Steuerstation aus umfasst.

4. Steuerverfahren nach Anspruch 1, wobei jede Last über einen Anschlussschalter (9) mit dem elektrischen Koppelnetz (5) verbunden ist, **dadurch gekennzeichnet, dass** das Verfahren einen Schritt des Bestimmens einer durch die prioritären Lasten (7) und durch die nicht prioritären Lasten (8) verbrauchten Leistung und einen Schritt des selektiven Trennens, der es gestattet, einen oder mehrere Anschlussschalter (9) von der entfernten Steuerstation aus zu öffnen, beinhaltet, sodass die Summe der durch die prioritären Lasten und durch die nicht prioritären Lasten verbrauchten Leistungen kleiner als die durch die Hilfsquelle bereitgestellte verfügbare Leistung ist.

5. Steuerverfahren nach Anspruch 1, wobei das elektrische Koppelnetz (5) ferner einen Koppelschalter (3) zwischen den prioritären Lasten (7) und den nicht prioritären Lasten (8) umfasst, **dadurch gekennzeichnet, dass** das Verfahren einen Schritt des Bestimmens einer durch die prioritären Lasten und durch die nicht prioritären Lasten verbrauchten Leistung und einen Schritt des Öffnens des Koppelschalters von der entfernten Steuerstation aus beinhaltet, um die nicht prioritären Lasten in dem Fall zu trennen, in dem die Summe der durch die prioritären Lasten und durch die nicht prioritären Lasten verbrauchten Leistungen größer als die durch die Hilfsquelle bereitgestellte verfügbare Leistung ist.

6. Steuerverfahren nach Anspruch 1, **dadurch gekennzeichnet, dass** es einen Vorabschritt des Sendens eines Befehls zum Starten des Hilfsgenerators von der entfernten Steuerstation aus umfasst.

7. Steuerverfahren nach Anspruch 1, **dadurch gekennzeichnet, dass** die Hilfsquelle mehrere Hilfsgeneratoren (20, 30) umfasst, die jeweils über einen Hilfsschalter (23, 33) parallel an das Koppelnetz (5) angeschlossen sind.

8. Steuerverfahren nach Anspruch 1, **dadurch gekennzeichnet, dass** die gemessenen elektrischen Größen die Amplitude, die Frequenz und den Phasenwinkel der Spannungen der Hauptquelle und der Hilfsquelle beinhalten.

## Claims

1. A method for controlling an electrical installation from a remote control station, the electrical installation comprising an electrical coupling network (5) powering one or more electrical loads (7, 8) distributed between so-called priority loads (7) and so-called non-priority loads (8), a main switch (13) to connect a main power source (10) to the coupling network (5) and an auxiliary switch (23) to connect an auxiliary power source (20) to the coupling network (5), the control method including:
- A step to determine a power consumed by the priority loads (7) and a decision-making step that authorises the implementation of the control method only if the power consumed by the priority loads (7) is less than an available power supplied by the auxiliary power source (20),
- A step to synchronise the auxiliary power source (20) with the main power source (10) including a phase of measuring electric data relative to the main power source and to the auxiliary power source and a verification phase, from the remote control station, to ensure that the measured electric data of the main power source and the auxiliary power source are compatible, and if, during the verification phase, the electric data measured relative to the main power source (10) and to the auxiliary power source (20) are not compatible, the synchronising step further comprises a phase to correct, from the remote control point, the parameters relative to the auxiliary power source (20),
- A step to send an order to close the auxiliary switch (23) from the remote control station,
- A step to send an order to open the main switch (13) from the remote control station,
- A step to check, from the remote control station, that load(s) (7, 8) is/are powered by the auxiliary power source (20).

2. The control method according to claim 1, **characterized in that**, after the checking step, the method then includes a second step to synchronise the auxiliary power source (20) with the main power source (10) comprising a phase to measure electric data relative to the main power source and to the auxiliary power source and a verification phase, from the remote control station, to ensure that the electric data measured of the main power source and the auxiliary power source are compatible.

3. The control method according to claim 2, **characterized in that**, after the second synchronisation step, the method includes a step to send an order to close the main switch (13) from the remote control station, then a step to send an order to open the auxiliary switch (23) from the remote control station.

4. The control method according to claim 1, wherein each load is connected to the electrical coupling network (5) by a connection switch (9), **characterized in that** the method comprises a step to determine a power consumed by the priority loads (7) and by the non-priority loads (8), and a selective disconnection step that allows one or more connection switches (9) to be opened, from the remote control station, so that the sum of the power consumed by the priority loads and by the non-priority loads is less than the available power supplied by the auxiliary power source.

5. The control method according to claim 1, wherein the electrical coupling network (5) also has a coupling switch (3) between the priority loads (7) and the non-priority loads (8), **characterized in that** the method comprises a step to determine a power consumed by the priority loads and by the non-priority loads, and a step to open the coupling switch, from the remote control station, to disconnect the non-priority loads, in the case where the sum of the power consumed by the priority loads and the non-priority loads is greater than the available power supplied by the auxiliary power source.

6. The control method according to claim 1, **characterized in that** it includes a preliminary step of sending an order to start the auxiliary generator from the remote control station.

7. The control method according to claim 1, **characterized in that** the auxiliary source has several auxiliary generators (20, 30) each connected in parallel to the coupling network (5) by an auxiliary switch (23, 33).

8. The control method according to claim 1, **characterized in that** the electric data measured include the amplitude, the frequency and the voltage angular phase of both the main power source and the auxiliary power source.
